# EUROPEAN PATENT APPLICATION

(11) **EP 2 051 299 A1**
(43) Date of publication of application: **22.04.2009**
(21) Application number: 08165984.9
(22) Date of filing: 07.10.2008
(51) Int. Cl.: H01L 23/467

(54) **Turbo-guiding type cooling apparatus**

(30) Priority: 17.10.2007 TW 96138787; 08.08.2008 TW 97130190
(71) Applicant: Cheng, Liang-Ho, Jhongli City, Taoyuan County 320 (TW)
(72) Inventor: Cheng, Liang-Ho, Jhongli City, Taoyuan County 320 (TW)
(74) Representative: Dossmann, Gérard

(57) **Abstract**

A turbo-guiding type cooling apparatus includes a reverse fixed blade unit (40) interposed between the wind exit surface of the fan (30) and the heat sink (20). The rotation direction of the reverse fixed blade unit (40) is opposite to that of the fan (30). A receiving chamber (45) is formed under the shaft of the reverse fixed blade unit (40), and the receiving chamber (45) has at least one-third height of the reverse fixed blade unit (40). A separation portion extending into the receiving chamber (45) is formed at the center of the top of at least one part of the heat sink. The reverse fixed blade unit (40) includes a reduction cover inward tapered at the periphery of the wind outlet thereof. The height (h1) of the periphery of the reduction cover is the same to or greater than the height (h2) of the periphery of the wind outlet (424) of the reverse fixed blade unit (40), thereby forming a ring-shaped enclosing type. Therefore, the wind will be smoothly concentrated and the flow direction will be changed. Meanwhile, each of the airflows will be separated by the separation portion (22) and delivered to the heat source of the heat sink (20).

## Description

### 1. Field of the Invention

The invention relates to a turbo-guiding type cooling apparatus, and more particularly to a structure that includes a reverse fixed blade unit and a reduction cover between a heat sink and a fan.

### 2. Description of the Related Art

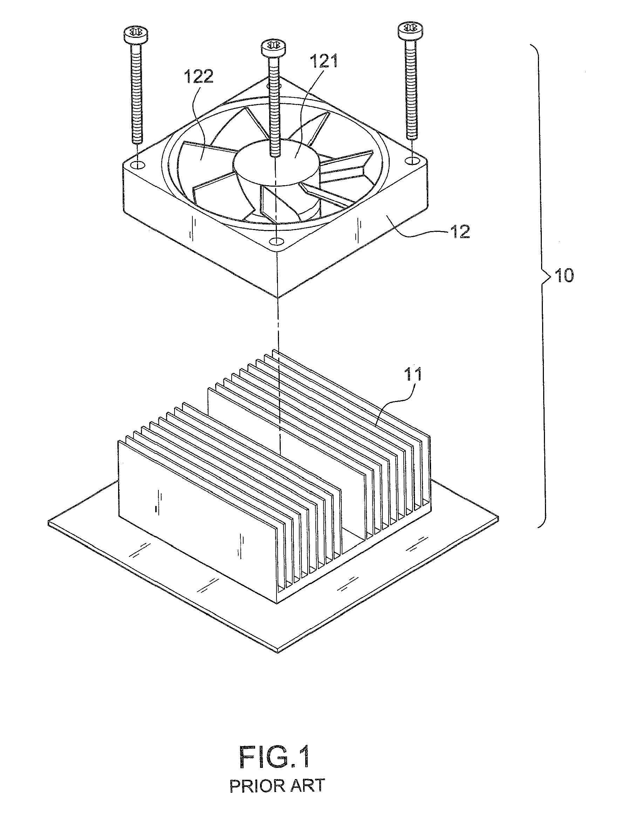

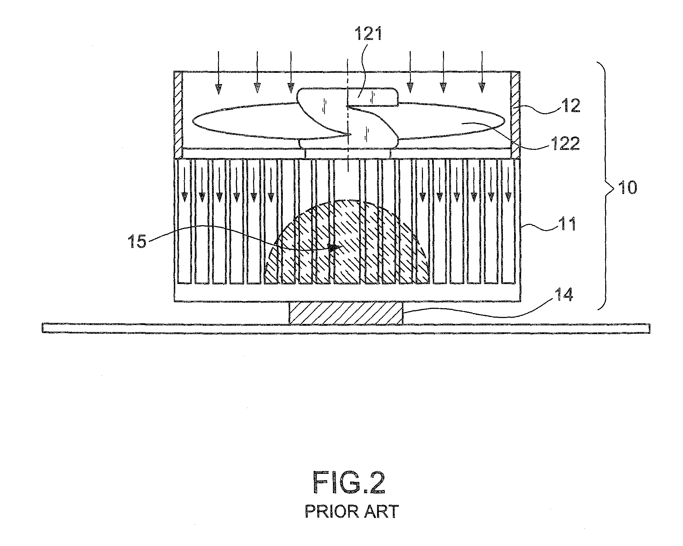

As shown in FIGS. 1 and 2, a conventional cooling apparatus 10 applied to CPU or other electronic chips includes a heat sink 11 having a plurality of fins and an axial flow fan 12 disposed at the top of the heat sink 11. The bottom of the heat sink 11 lies on the surface of the electronic chip (or heat source 14). After the operation of the fan 12, the heat energy of the heat source 14 can be transmitted to all fins of the heat sink 11 by use of the heat conduction. Meanwhile, the cool air generated by the fan 12 is delivered to the fins of the heat sink 11 for conducting the heat exchange. In the way, the heat energy is removed.

However, the conventional fan 12 belongs to an axial flow type. All of blades 122 of the fan 12 are extended outward from a shaft portion 121 at the center thereof. Many components like motor are received within the shaft portion 121. Therefore, the shaft portion 121 occupies a considerable space. The area adjacent to the heat zone 15 under the shaft portion 121 obtains less cooling air when the fan 12 is operated. In other words, the cooling fins at the area of the heat zone 15 can hardly achieve the heat removal by cool air. Moreover, the heat source 14 is aligned to the shaft portion 121 of the fan 12 when the cooling apparatus 10 is installed. Therefore, the current of air and the wind pressure generated by the fan 12 can not be transmitted to the heat zone 15 of the heat sink 11 most adjacent to the heat source 14. Therefore, the heat-removal efficiency is reduced.

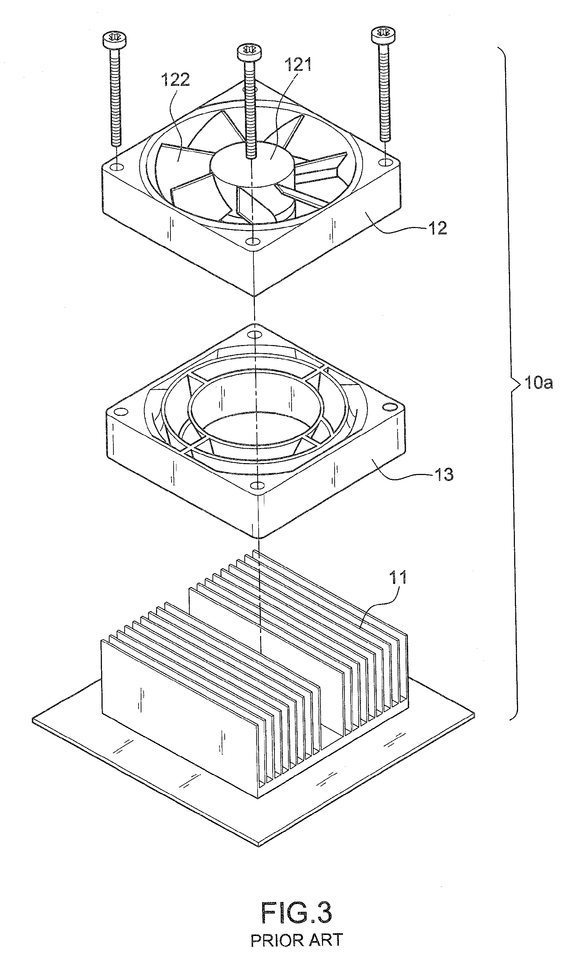

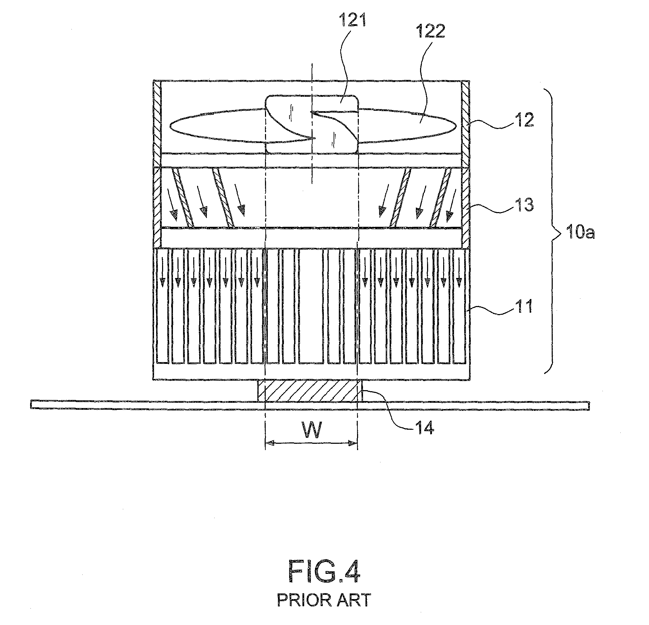

As shown in FIGS. 3 and 4, another conventional cooling apparatus 10a includes an inclined and conic wind-guiding ring 13 between a heat sink 11 and a fan 12. The wind-guiding ring 13 is provided for delivering the current of air generated by the fan 12 to a region covered by the shaft portion 121 at the center of the fan 12 such that the cooling air can reach the part of the heat sink 11 most adjacent to the heat source 14. It is expected to enhance the heat-removal efficiency. This structure is disclosed by TW M259469.

It is correct for the above-mentioned cooling apparatus 10a to deliver the current of air to the center. However, the effect achieved by the inclined and conic wind-guiding ring 13 can be very limited since it can only achieve a slight change of wind-delivering angle. Likewise, the cooling air can hardly reach the view field (w) under the shaft portion 121, that is, the position of the heat source 14. Thus, the heat-removal efficiency can't be considerably enhanced as well, and this requires further improvement.

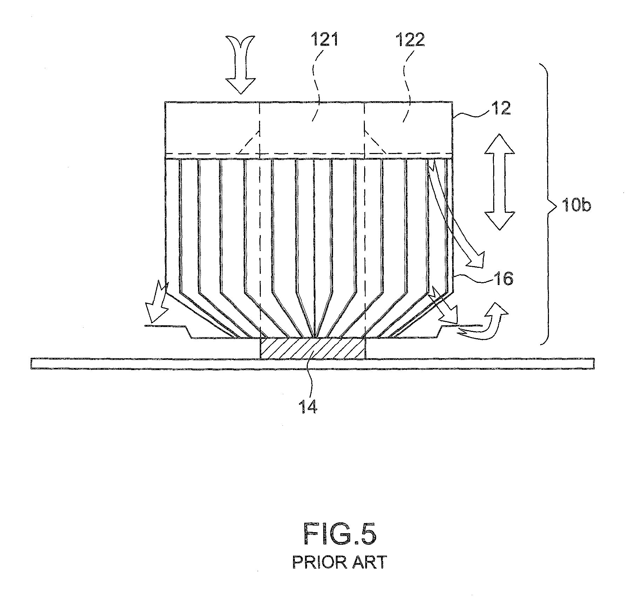

As shown in FIG. 5, a further cooling apparatus 10b includes heat-removal fins 16 in a vertical arrangement. It is different from the above-mentioned heat-removal fins 16 in a horizontal arrangement. No matter if the cooling apparatus is in a horizontal arrangement or in a vertical arrangement, they all have the above-mentioned problem with respect to the heat removal.

The turbo-supercharging principle has been widely applied to many pneumatic products, such as suction opening of the jet engine, accelerator for automotive engines, particle vacuum pumps, etc. The operating principle of these devices lies in that the rotary blades and the reverse blades fixed at the rim are assembled to be a blade unit. The high-speed rotary blades delivers current of air to the reverse blades fixed at the rim such that the airflow pressure can be rapidly enhanced between the rotary blades and the reverse blades fixed at the rim. This is the principle of the well-known turbo-supercharging process.

Many cooling fans or ventilators are provided with the turbine device. However, most of them only combine one turbine fan and the cooling fins or employ a fan blowing to a reverse eddy-shaped and non-bladeshaped partitions regularly spaced. The turbo-supercharging structure occupies a greater space and is aimed to enhance the wind pressure. However, this can cause a power loss due to return pressure created by these cooling apparatuses. Consequently, these conventional apparatuses are not applicable.

A primary object of the invention is to provide a turbo-guiding type cooling apparatus that smoothly delivers the current of air generated by a fan to a heat sink such that a heat exchange takes place in a heat region where the current of air within the heat sink does not reach easily. In other words, the heat region can be cooled by the injected current of air such that the heat energy can be smoothly removed for enhancing the heat-removal efficiency.

Another object of the invention is to provide a turbo-guiding type cooling apparatus that ensures an extended service life of electronic chips and increases their reliability. Moreover, the heat-removal volume is diminished for saving precious space. Meanwhile, an unnecessary material waste is avoided. In addition, it is not necessary to use high-speed fan so that the noise can be reduced.

In order to achieve the above-mentioned objects, the invention has the following features:

A reverse fixed blade unit is interposed between the wind exit surface of the fan and the heat sink. The rotation direction of the reverse fixed blade unit is opposite to that of the fan. A receiving chamber is formed under the shaft of the reverse fixed blade unit, and the receiving chamber has at least one-third height of the reverse fixed blade unit.

A separation portion extending into the receiving chamber is formed at the center of the top of at least one part of the heat sink.

The reverse fixed blade unit includes a reduction cover inward tapered at the periphery of the wind outlet thereof. The height (h1) of the periphery of the reduction cover is the same to or greater than the height (h2) of the periphery of the wind outlet of the reverse fixed blade unit, thereby forming a ring-shaped enclosing type. Therefore, the wind will be smoothly concentrated and the flow direction will be changed. Meanwhile, each of the airflows will be separated by the separation portion and delivered to the heat source of the heat sink.

Based on the above-mentioned features, the turbo-guiding type cooling apparatus includes a reverse fixed blade unit and a reduction cover. A receiving chamber is formed under the shaft of the reverse fixed blade unit into which the separation portion is extended. In this way, a concentrated airflow can be delivered to the front side of a heat region of the cooling fins. The idea of smooth guiding of the airflow and the structure appearance is partially similar to the turbo-supercharging principle. The main feature of the invention lies in "diversion" (flow-guiding). In other words, the reverse fixed blade unit within the reduction cover, the flow-guiding chamber under the shaft, and the extending reduction cover are well employed for conducting the flow-guiding task. Therefore, it is not necessary for the invention to have a high rotation speed required by the turbine. Meanwhile, components such as coupling und gear mechanism are also not required for pressure rise. This feature is therefore called as "turbo-guiding" that shows a distinct difference from the conventional "turbo-supercharging".

The configuration of the reverse fixed blade unit and the reduction cover is simple and can achieve the heat-removal effect. In this way, the whole volume can be so properly reduced that the dimensions of the entire cooling apparatus won't be increased to occupy much space. It is therefore beneficial to arrange electronic components in the computer. The reverse fixed blade unit of the invention can be disposed within an independent mounting frame as the need arises. Alternatively, it can be designed to be a turbo-guiding type fan that is combined with a reduction cover and a heat-conducting module. In addition, it can be integrally formed with the fins of the heat sink.

No matter which of the above-mentioned embodiments is applied, a concentrated current of air directed to the heat source can be obtained. Meanwhile, the vibration and the noise generated by wind pressure can be avoided. Moreover, an optimal value of wind pressure and wind quantity can be obtained without problem under the condition of the least power loss, thereby optimizing the heat-removal efficiency. Thus, the invention can eliminate the problem of the conventional heat sink and is really an effective cooling apparatus applicable in the electronic industry.

The accomplishment of this and other objects of the invention will become apparent from the following descriptions and its accompanying figures of which:
FIG. 1 is an exploded perspective view of a conventional horizontal type cooling apparatus;
FIG. 2 is a cross-sectional view of the conventional horizontal type cooling apparatus after assembly;
FIG. 3 is an exploded perspective view of another conventional horizontal type cooling apparatus;
FIG. 4 is a cross-sectional view of another conventional horizontal type cooling apparatus after assembly;
FIG. 5 is a schematic drawing of a conventional vertical type cooling apparatus;
FIG. 6 is an exploded perspective view of a first embodiment of the invention;
FIG. 7 is a cross-sectional view of the first embodiment of the invention;
FIG. 8 is a perspective view of a second embodiment of the invention;
FIG. 9 is a perspective view of a third embodiment of the invention;
FIG. 10 is an exploded perspective view of a fourth embodiment of the invention;
FIG. 11 is an exploded perspective view of a fifth embodiment of the invention;
FIG. 12A is a top view of a vertical type cooling fins in FIG. 11;
FIG. 12B is a cross-sectional view taken along the line 12B-12B in FIG. 12A;
FIG. 13A is a top view of a reduction cover in FIG. 11;
FIG. 13B is a cross-sectional view taken along the line 13B-13B in FIG. 13A;
FIG. 14A is a top view of a reverse fixed blade unit 40 in FIG. 11;
FIG. 14B is a cross-sectional view taken along the line 14B-14B in FIG. 14A;
FIG. 14C is a cross-sectional view taken along the line 14C-14C in FIG. 14A;
FIG. 15A and 15B are cross-sectional views of the embodiment in FIG. 11;
FIG. 16 is a perspective view of a sixth embodiment of the invention;
FIG. 17 is an exploded cutaway view of the sixth embodiment of the invention;
FIG. 18 is a cutaway view of a seventh embodiment of the invention after assembly;
FIG. 19 is an exploded perspective view of the seventh embodiment of the invention;
FIG. 20 is a perspective view of the seventh embodiment of the invention after assembly;
FIG. 21 is an exploded perspective view of an eighth embodiment of the invention;
FIG. 22 is an assembly perspective view of partial components of the eighth embodiment of the invention; and
FIG. 23 is a cutaway view of the eighth embodiment of the invention.

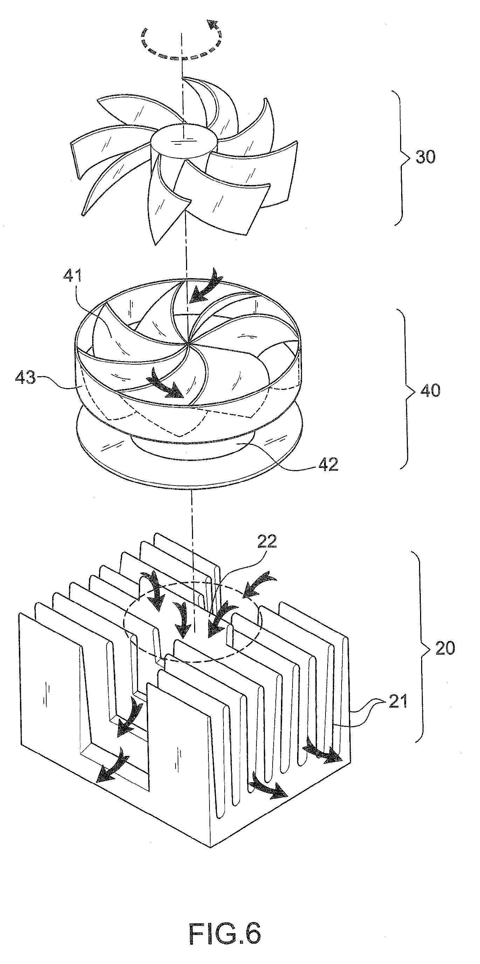

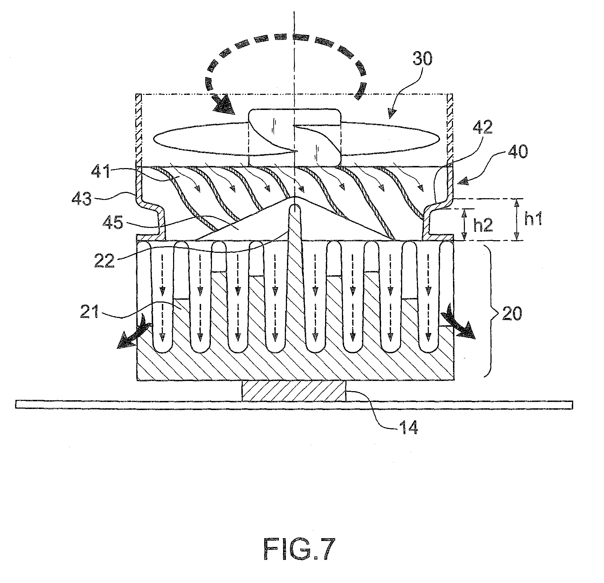

First of all, referring to FIGS. 6 and 7, a turbo-guiding type cooling apparatus in accordance with the invention includes a heat sink 20, and a fan 30.

The heat sink 20 includes a plurality of horizontal type cooling fins 21. According to the embodiment, the heat sink 20 belongs to a horizontal type heat sink. It should not be restricted thereto. The configuration of the invention can be also applied to the vertical type heat sink or heat-conducting module. These will be descried in detail hereinafter. The heat sink 20 is not the object of the invention so that no further descriptions thereto are given hereinafter.

The fan 30 is disposed at the top of the heat sink 20. According to the invention, the fan 30 is an axial-flow fan so that the heat exchange takes place by delivering cool air downward to the heat sink 20.

The invention features a reverse fixed blade unit 40 interposed between the wind exit surface of the fan 30 and the heat sink 20. The rotation direction of the reverse fixed blade unit 40 is opposite to that of the fan 30. A receiving chamber 45 is formed under the shaft of the reverse fixed blade unit 40. The receiving chamber 45 must have at least one-third height of the reverse fixed blade unit 40. Two-third height thereof or more than two-third height thereof is preferred.

A separation portion 22 extending into the receiving chamber 45 is formed at the center of the top of the heat sink 20.

The reverse fixed blade unit 40 includes a reduction cover 42 inward tapered at the periphery of the wind outlet thereof. The height h1 of the periphery of the reduction cover 42 is the same to or greater than the height h2 of the periphery of the wind outlet of the reverse fixed blade unit 40, thereby forming a ring-shaped enclosing type. In this way, the wind will be smoothly concentrated and the flow direction will be changed. Meanwhile, each of the air flows will be separated by the separation portion 22 and delivered to the heat source of the heat sink 20.

According to the embodiment of the invention, the separation portion 22 includes projecting fins. There are one or several fins depending on the requirements.

In order to gather up the air flow and then to deliver it to the heat source, the fan 30 is employed to replace the conventional turbo-supercharging and super high-speed shaft blade. Moreover, the shape, the number of blades and the gap of the reverse fixed blade unit 40 must be designed according to the rotation speed of the fan 30 and the blade shape for achieving the flow-guiding effect.

Based on such the above-mentioned combination, the shaft of the reverse fixed blade unit 40 serves as wind outlet and is enclosed by the reduction cover 42 at the ring side. In this way, the airflow can be smoothly gathered together by means of the eddy guide. Besides, each of the airflows can be separated by means of the separation portion 22 extending to the bottom of the shaft of the reverse fixed blade unit 40. Meanwhile, the airflows are delivered to the heat source. The object of the invention lies in the smooth diversion rather than the conventional turbo-supercharging process for increasing the wind pressure. In other words, the main effect of the invention is the gathering of the wind amount. The increase of the wind pressure is not the object of the invention.

Based on the above-mentioned means, the invention includes the following embodiments.

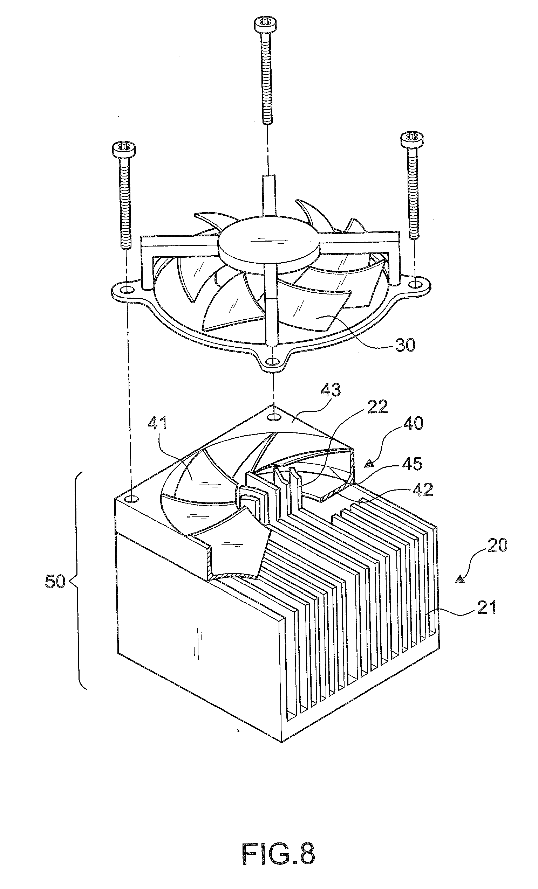

First of all, referring to FIG. 8, the reverse fixed blade unit 40 is disposed within an independent mounting frame 43 in such a way that it serves as a connection base for the fan 30 and the heat sink 20. In other words, the structure is created by assembling the above-mentioned three individual components one after the other.

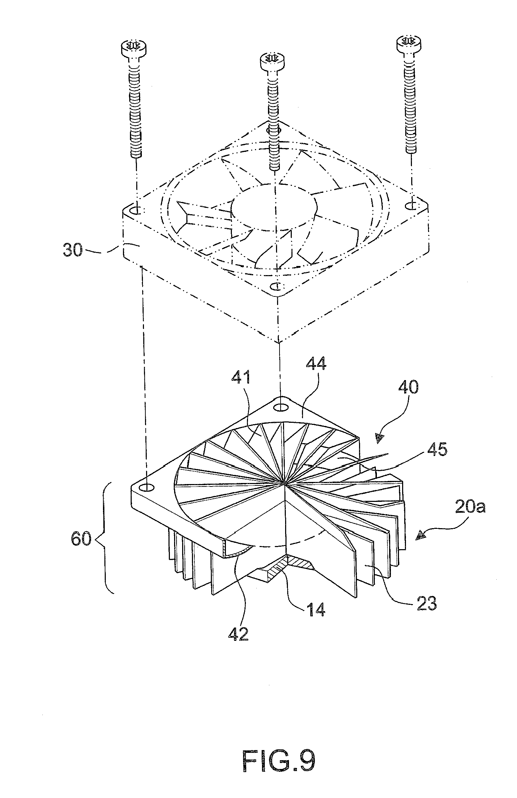

As shown in FIG. 9, which illustrates another embodiment of the reverse fixed blade unit 40, vertical fins 23 of the heat sink 20a are integrally formed with the reverse fixed blade unit 40 so as to create a turbo-guiding type cooling apparatus 60. Thereafter, the fan 30 is installed thereon. This embodiment is more suitable for the vertical type cooling apparatus. Vortex type blades 41 can be directly formed by bending the upper portion of the vertical fins 23 counterclockwise or clockwise. A blade socket 44 is mounted at the periphery of the blades 41. In this way, the reverse fixed blade unit 40 and the heat sink 20a are integrally combined for different application requirements.

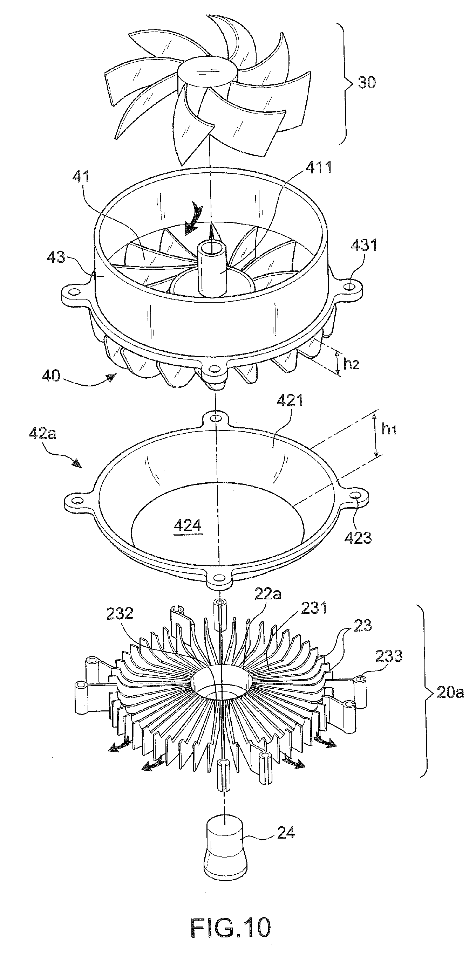

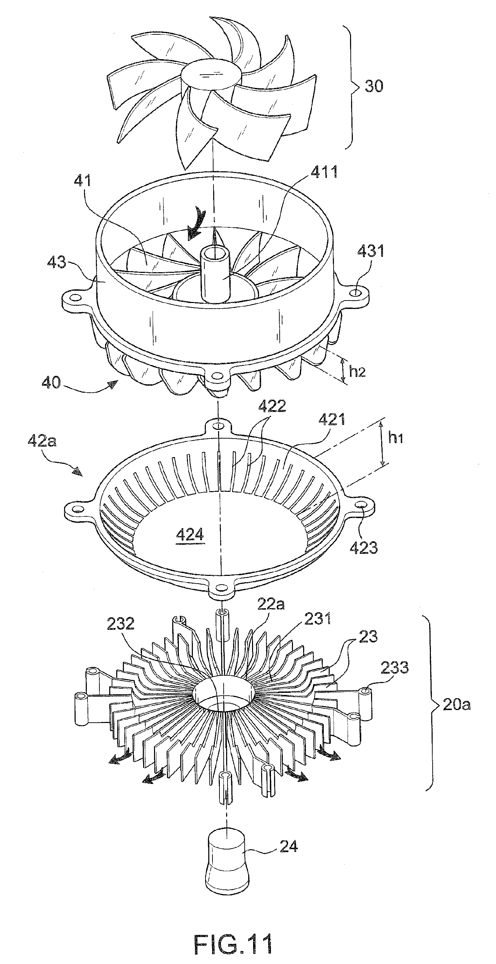

Based on the above-mentioned features, a preferred application is shown in FIGS. 10 through 16. The same components are marked with the same reference sign. The difference between FIG. 10 and 11 lies only in that the tapered portion 421 of the reduction cover 42a in FIG. 10 is an substantially arched body without recesses while the tapered portion 421 of the reduction cover 42a in FIG. 11 includes radial recesses 422. The other parts are the same. The embodiment of the invention according to FIGS. 11 through 15 includes a heat sink 20a consisting of a plurality of vertical fins 23 and a fan 30 disposed at the top of the heat sink 20a.

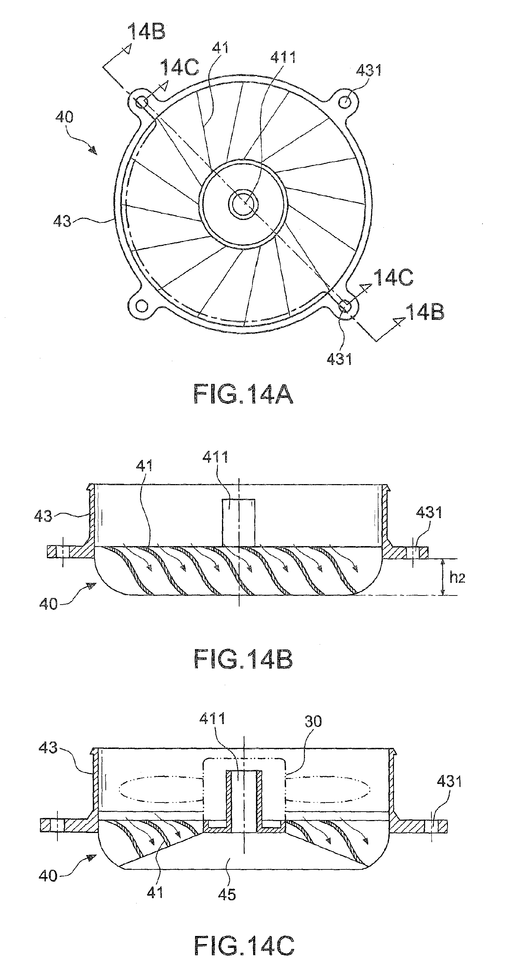

The invention features a reverse fixed blade unit 40 interposed between the wind exit surface of the fan 30 and the heat sink 20a. The rotation direction of the reverse fixed blade unit 40 is opposite to that of the fan 30. As shown in FIG. 14C, A receiving chamber 45 is formed under a shaft 411 of the reverse fixed blade unit 40. The receiving chamber 45 must have at least one-third height of the reverse fixed blade unit 40. Moreover, a mounting frame 43 and a shaft 411 are attached to the reverse fixed blade unit 40 for installing the fan 30 thereon.

The heat sink 20a consists of a plurality of vertical fins 23 arranged in a radiating manner. The heat sink 20a includes a ring groove 231 and a middle hole 232. Meanwhile, a projecting separation portion 22a extending into the receiving chamber 45 is formed at the ring groove 231 facing the middle hole 232. According to the embodiment, the separation portion 22a is an inclined cone created by the central part of the vertical fins 23.

A reduction cover 42a is interposed between the heat sink 20a and the reverse fixed blade unit 40. The reduction cover 42a has an inward tapered portion 421. The center thereof is hollow to create a wind outlet 424. The tapered portion 421 lies at the periphery of the ring groove 231 of the vertical fins 23. The height h1 of the periphery of the cover is the same to or greater than the height h2 of the periphery of the wind outlet of the reverse fixed blade unit 40, thereby forming a ring-shaped enclosing type. In this way, the wind will be smoothly concentrated and the flow direction will be changed. Meanwhile, each of the air flows will be separated by the separation portion 22a and delivered to the heat source of the heat sink 20.

As shown in FIGS. 11, 14A∼14C, the mounting frame 43 of the reverse fixed blade unit 40 further includes a shaft 411 at the center thereof for fixing the fan 30 in place.

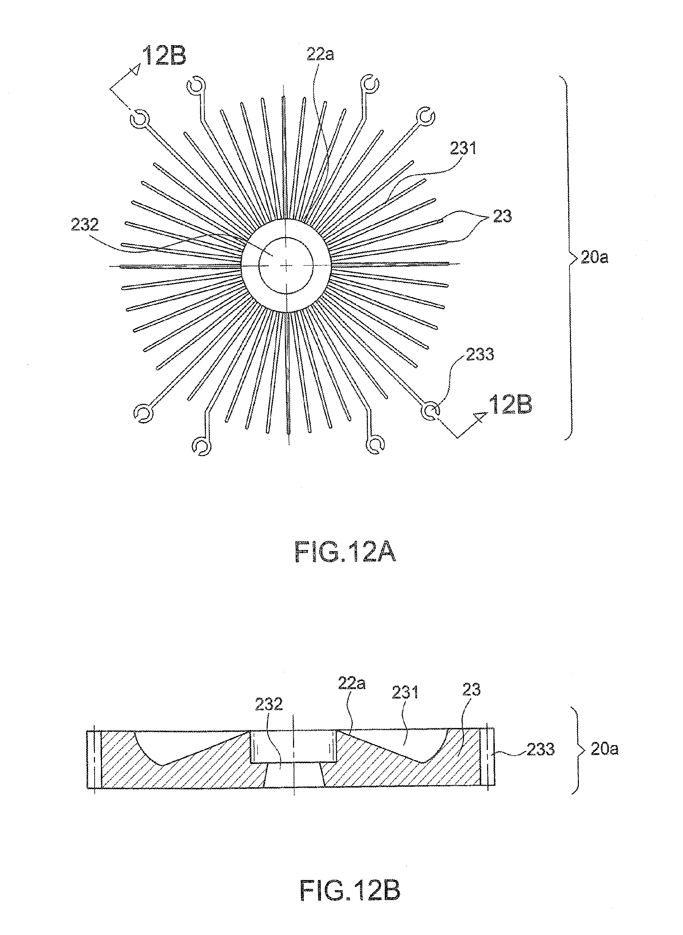

Besides, a ring groove 231 and a middle hole 232 are illustrated in FIGS. 12A and 12B. Meanwhile, several vertical fins 23 are extended outward to create a screw connection portion 233.

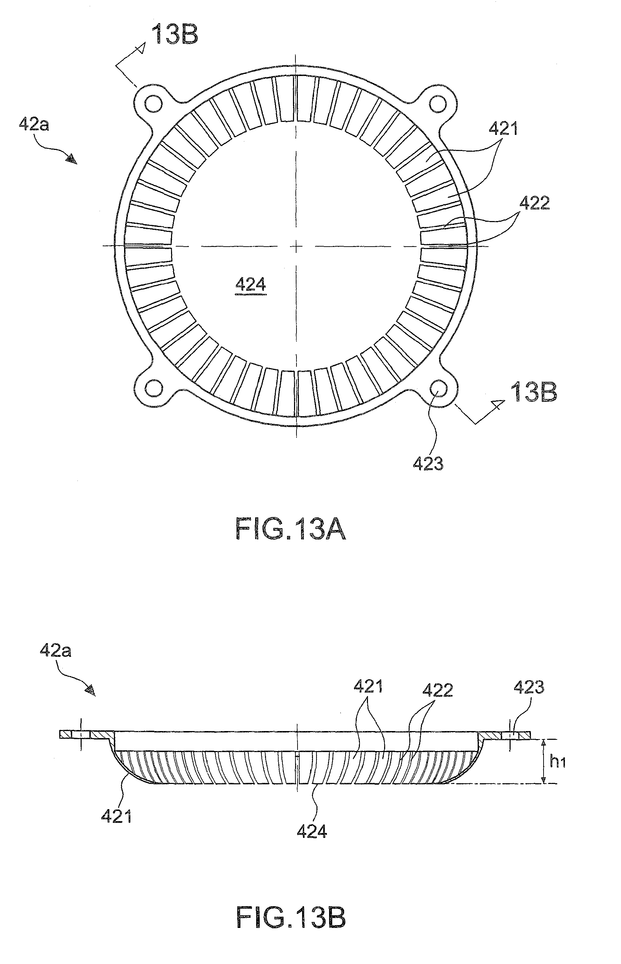

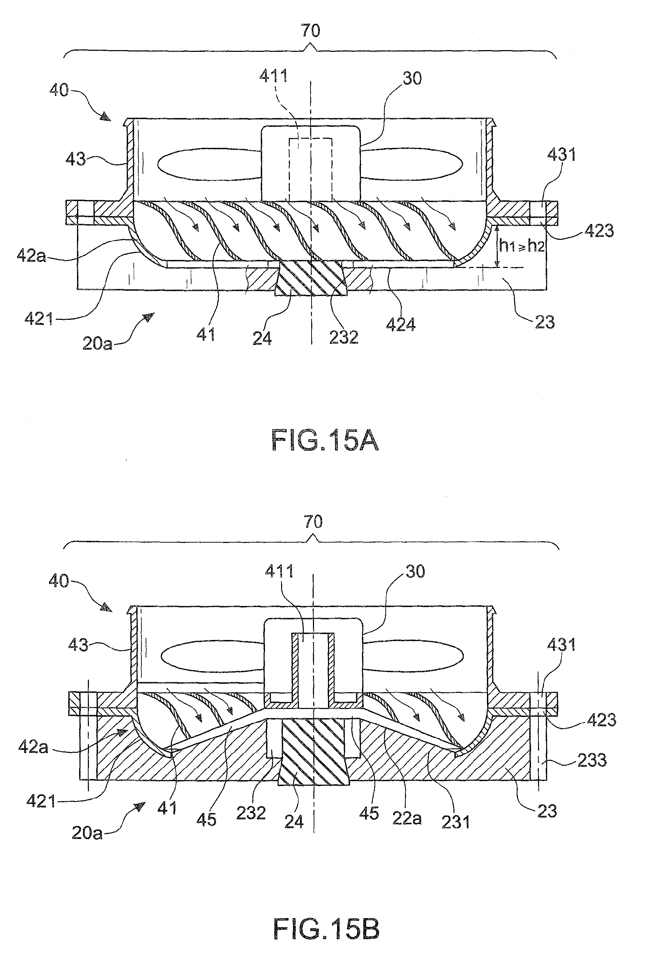

FIGS. 13A and 13B are a top view and a cutaway view of the reduction cover 42a in FIG. 11. As shown in FIGS. 15A and 15B, the heat sink 20a, the reduction cover 42a, the reverse fixed blade unit 40, and the fan 30 are assembled to create a turbo-guiding type cooling apparatus 70. The feature of this embodiment is the same to that of the previous embodiments. Moreover, the spacial assembly structure is more concrete. The screw connection portions 233, 423 of the heat sink 20, the reduction cover 42a, and the mounting frame 43 can be fixed by screws (not shown) or other elements to complete the assembly. In addition, a heat-conducting module 24 is formed at the bottom of the middle hole 232 of the heat sink 20a for enhancing the heat-removal effect.

As shown in FIG. 10, the reduction cover 42a has a tapered portion 421 without recesses. The arched body is disposed at the periphery of the ring groove 231 of the vertical fins 23. As shown in FIG. 11, radial recesses 422 are present for the insertion of the tapered portion 421 into the vertical fins 23. These two embodiments are also formed in a ring-shaped enclosing type.

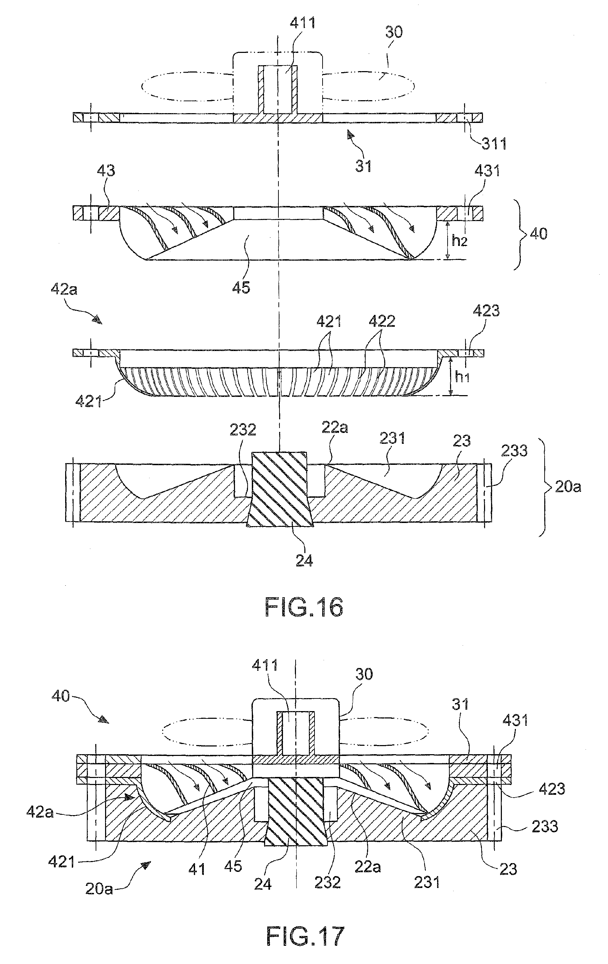

As shown in FIGS. 16 and 17, the top of the mounting frame 43 is flat and has no room for mounting the fan 30 in place. Therefore, an independent mounting base 31 is disposed at the top of the mounting frame and fitted with a shaft 411 at the center thereof for mounting the fan 30 in place. Thereafter, the combination body is fixed on the mounting frame 43. The other components are the same to that of the previous embodiments so that no further descriptions thereto are given hereinafter.

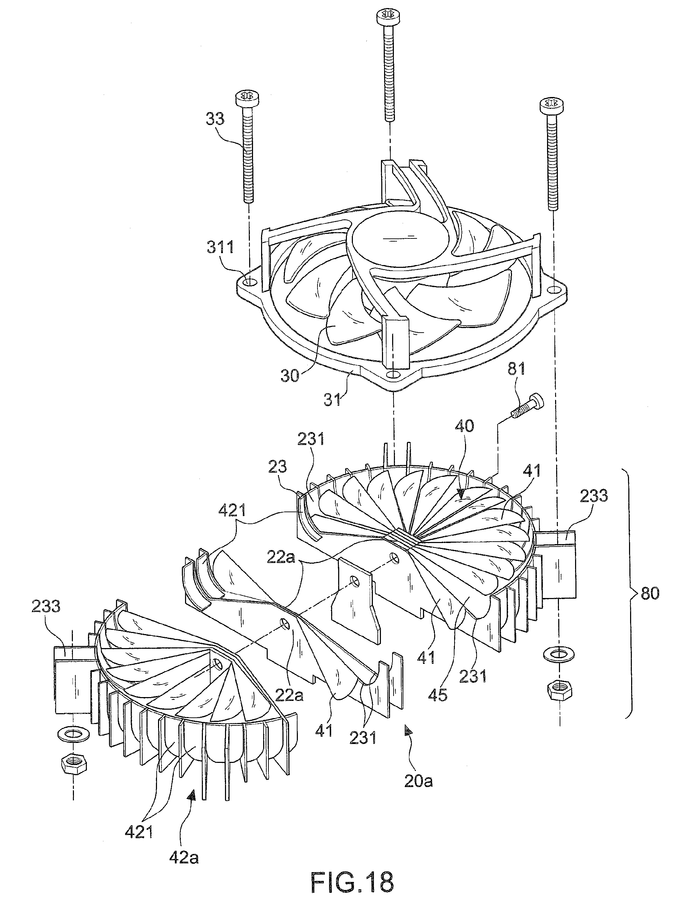

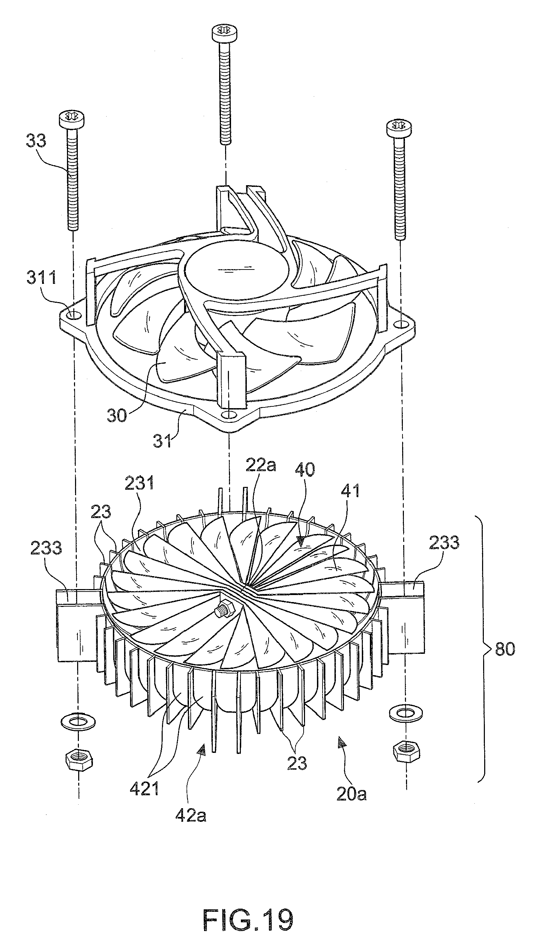

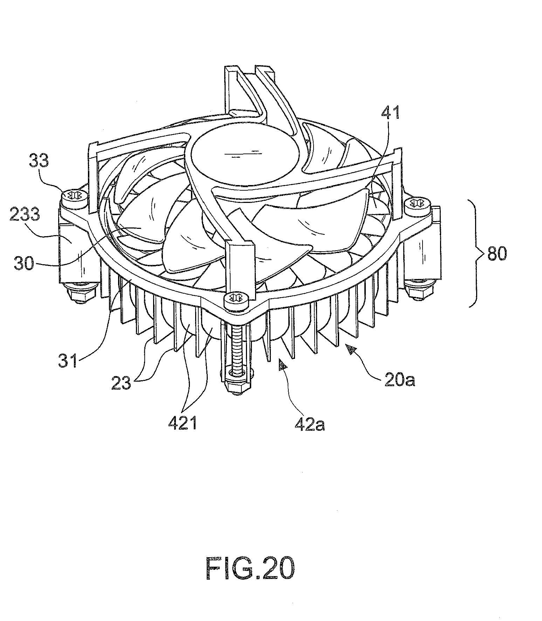

As shown in FIGS. 18 through 20, the heat sink 20a, the reverse fixed blade unit 40, and the reduction cover 42a are integrally formed. The features thereof substantially correspond to that in FIG. 9. The periphery of the blades 41 in FIG. 9 includes a blade socket 44, and the reduction cover 42 is disposed at the bottom of the blade socket 44. According to this embodiment, the vortex type blades 41 of the reverse fixed blade unit 40 are directly formed at the reduction cover 42a. Meanwhile, the tapered portion 421 of the reduction cover 42a is also formed in the gaps between the cooling fins 21. The heat sink 20a, the reverse fixed blade unit 40, and the reduction cover 42a are integrally formed by an integral module 80 that is made by a plurality of the metal pieces in stamping and bending process. Meanwhile, fixing elements 81 are employed to combine them in an integral structure. Meanwhile, the fan 30 is mounted within a mounting base 31 and then disposed on the heat sink 20a by several screws 33 extending through the screw connection portions 311, 233. According to this embodiment, an integral module 80 is employed for a convenient assembly of the mounting base 31 of the conventional fan 30. Therefore, this embodiment is different from the previous embodiment only in the assembly and processing way. The other structure and features are the same to that of the other embodiment so that no further descriptions thereto are given hereinafter.

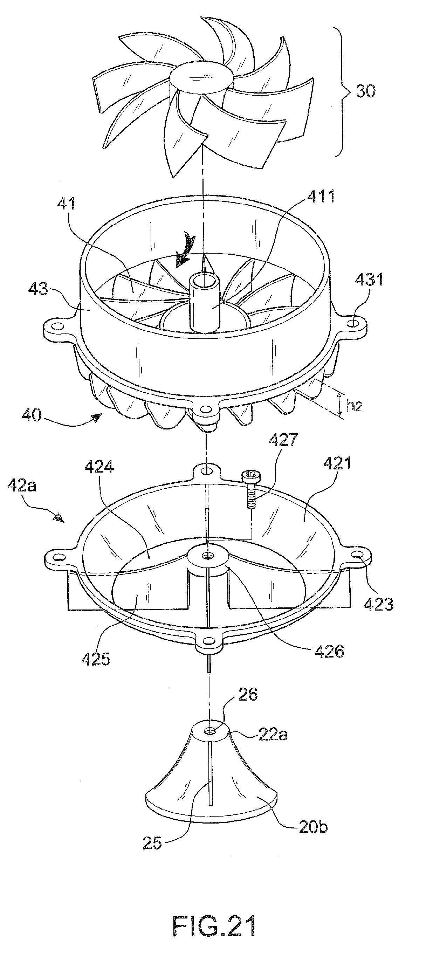

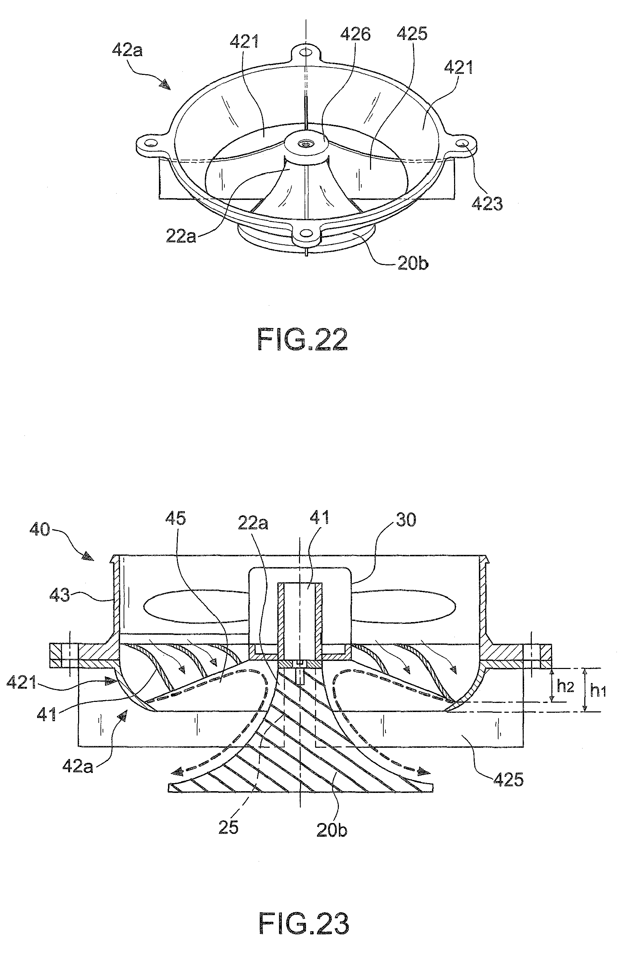

FIGS. 21 through 23 illustrate a further embodiment of the invention. The same components are marked with the same reference signs. The difference is detailed hereinafter.

The heat sink is a heat-conducting module 20b. According to a preferred embodiment, the periphery is formed in a conic and arched shape. A projecting separation portion 22a extending into the receiving chamber 45 is disposed at the top of the heat sink 20b. Meanwhile, several radial recesses 25 are formed in the conic surface of the heat sink 20b.

As for the reduction cover 42a, the tapered portion 421 thereof does not have recesses. However, several straight fins 425 are provided at the wind outlet 424 for engaging into radial recesses 25 of the heat sink 20b. According to a preferred embodiment, the straight fin 425 has a connection surface 426 in the middle thereof and is fixed by a screw 427 fitting into a connection hole 26 at the top of the heat sink 20b. Likewise, the height h1 of the periphery of the reduction cover 42a is the same to or greater than the height h2 of the periphery of the wind outlet of the reverse fixed blade unit 40, thereby forming a ring-shaped enclosing type. The function is the same to that of the previous embodiments so that no further descriptions thereto are given hereinafter.

According to the above-mentioned embodiments, a few common features are concluded as follows:
1. A receiving chamber 45 extending to the bottom over more than one-third height thereof is formed under the shaft of the reverse fixed blade unit 40. Preferably, the receiving chamber 45 is extended from the periphery to the center thereof in an inclined type.
2. No matter if the heat sink consists of fins or is formed by a heat-conducting module, a projecting separation portion 22, 22a extending to the receiving chamber 45 is formed at the center of the heat sink for separating different airflows.
3. The reverse fixed blade unit 40 includes an enclosing reduction cover 42, 42a at the periphery of the wind outlet thereof. The height h1 of the periphery of the reduction cover is the same to or greater than the height h2 of the periphery of the wind outlet of the reverse fixed blade unit 40 In this way, the wind will be smoothly delivered to the heat source of the heat sink 20. Moreover, the reduction cover is provided with recesses or without recesses for an easy connection to the heat sink. Of course, the reduction cover can be integrally formed with the heat sink in a stamping process. Furthermore, the fins 425 are provided for a direct connection with the heat-conducting module 20b. Therefore, the above-mentioned variations are within the scope of the invention and can fulfill the requirement of the heat-removal efficiency.

Many changes and modifications in the above-descried embodiments of the invention can, of course, be carried out without departing from the scope thereof. Accordingly, to promote the progress in science and the useful arts, the invention is disclosed and is intended to be limited only by the scope of the appended claims.

## Claims

1. A turbo-guiding type cooling apparatus, comprising:
a) a heat sink (20) consisting of a plurality of fins (21); and
b) a fan (30) disposed at the top of the heat sink (20),
wherein a reverse fixed blade unit (40) is interposed between the wind exit surface of the fan and the heat sink (20), and the rotation direction of the reverse fixed blade unit (40) is opposite to that of the fan (30), and a receiving chamber (45) is formed under the shaft of the reverse fixed blade unit (40), and the receiving chamber (45) has at least one-third height of the reverse fixed blade unit (40);
wherein a separation portion extending into the receiving chamber (45) is formed at the center of the top of at least one part of the heat sink (20); and
wherein the reverse fixed blade unit (40) includes a reduction cover (42) inward tapered at the periphery of the wind outlet thereof, and the height (h1) of the periphery of the reduction cover (42) is the same to or greater than the height (h2) of the periphery of the wind outlet (424) of the reverse fixed blade unit (40), thereby forming a ring-shaped enclosing type; therefore, the wind will be smoothly concentrated and the flow direction will be changed; meanwhile, each of the air flows will be separated by the separation portion (22) and delivered to the heat source of the heat sink (20).

2. The turbo-guiding type cooling apparatus as recited in claim 1 wherein the fin (21) of the heat sink (20) is selected from a group consisting of horizontal and vertical type fin.

3. The turbo-guiding type cooling apparatus as recited in claim 1 wherein the separation portion (22) at the top of the heat sink (20) includes one or several projecting fins.

4. The turbo-guiding type cooling apparatus as recited in claim 1 wherein the reverse fixed blade unit (40) is disposed within an independent mounting frame (43), and the reduction cover (42) is integrally formed at the bottom rim of the mounting frame (43) in such a way that the mounting frame (43) serves as a connection base (50) for the fan (30) and the heat sink (20).

5. The turbo-guiding type cooling apparatus as recited in claim 1 wherein the reverse fixed blade unit (40) and the fins (23) of the heat sink (20a) are integrally formed.

6. The turbo-guiding type cooling apparatus as recited in claim 5 wherein a blade socket (44) is mounted at the periphery of the blade, and the reduction cover (42) is formed at the bottom rim of the blade socket (44).

7. A turbo-guiding type cooling apparatus, comprising:
a) a heat sink (20a) consisting of a plurality of fins (23); and
b) a fan (30) disposed at the top of the heat sink (20a),
wherein a reverse fixed blade unit (40) is interposed between the wind exit surface of the fan (30) and the heat sink (20a), and the rotation direction of the reverse fixed blade unit (40) is opposite to that of the fan (30), and a receiving chamber (45) is formed under the shaft (411) of the reverse fixed blade unit (40), and the receiving chamber (45) has at least one-third height of the reverse fixed blade unit (40), and a mounting frame (43) is disposed on the reverse fixed blade unit (40) for mounting the fan (30) thereon;
wherein the heat sink (20a) consists of a plurality of vertical fins (23) arranged in a radiating manner, and the heat sink (20a) includes a ring groove (231) and a middle hole (232), and a projecting separation portion (22a) extending into the receiving chamber (45) is formed at the ring groove (231) facing the middle hole (232); and
wherein a reduction cover (42a) is interposed between the heat sink (20a) and the reverse fixed blade unit (40), and the reduction cover (42a) has an inward tapered portion (421) while the center thereof is hollow to create a wind outlet (424), and the tapered portion (421) lies at the periphery of the ring groove (231) of the vertical fins (23), and the height (h1) of the periphery of the cover is the same to or greater than the height (h2) of the periphery of the wind outlet of the reverse fixed blade unit (40), thereby forming a ring-shaped enclosing type such that the wind will be smoothly concentrated and the flow direction will be changed; meanwhile, each of the air flows will be separated by the separation portion (22a) and delivered to the heat source of the heat sink (20).

8. The turbo-guiding type cooling apparatus as recited in claim 7 wherein the tapered portion (421) of the reduction cover (42a) includes an arched body without recesses and lies at the periphery of the ring groove (23 1) of the vertical fins (23).

9. The turbo-guiding type cooling apparatus as recited in claim 7 wherein the tapered portion (421) the reduction cover (42a) includes radial recesses (422) into which the vertical fins (23) of the heat sink (20a) fit.

10. The turbo-guiding type cooling apparatus as recited in claim 7 wherein the mounting frame (43) is provided with a shaft at the center thereof for fixing the fan (30) in place.

11. The turbo-guiding type cooling apparatus as recited in claim 7 wherein the mounting frame (43) further includes an independent mounting base (31) at the top thereof for fixing the fan (30) in place.

12. The turbo-guiding type cooling apparatus as recited in claim 7 wherein the heat sink (20a) further includes a heat-conducting (24) module at the bottom of the middle hole (232) thereof.

13. The turbo-guiding type cooling apparatus as recited in claim 7 wherein The heat sink (20a), the reverse fixed blade unit (40), and the reduction cover (42a) are integrally formed by an integral module that is made by a plurality of the metal pieces in stamping and bending process, and fixing elements (81) are employed to combine them in an integral structure, and the fan (30) is mounted within a mounting base (31) and then disposed on the heat sink (20a) by several screws (33).

14. A turbo-guiding type cooling apparatus, comprising:
a) a heat sink (20b); and
b) a fan (30) disposed at the top of the heat sink (20b),
wherein a reverse fixed blade unit (40) is interposed between the wind exit surface of the fan (30) and the heat sink (20b), and the rotation direction of the reverse fixed blade unit (40) is opposite to that of the fan (30), and a receiving chamber (45) is formed under the shaft of the reverse fixed blade unit (40), and the receiving chamber (45) has at least one-third height of the reverse fixed blade unit (40), and s mounting frame (43) is disposed on the reverse fixed blade unit (40) for mounting the fan (30) thereon;
wherein the heat sink (20b) includes a heat-conducting module, and a projecting separation body extending into the receiving chamber (45) is formed at the top thereof, and the heat sink (20b) is provided with a plurality of radial recesses (25); and
wherein a reduction cover (42a) is interposed between the heat sink (20b) and the reverse fixed blade unit (40), and the reduction cover (42a) has an inward tapered portion (421) while the center thereof is hollow to create a wind outlet (424) having a plurality of straight fins (425) engaging into the radial recesses (25) of the heat sink (20b), and the height (h1) of the periphery of the cover is the same to or greater than the height (h2) of the periphery of the wind outlet (424) of the reverse fixed blade unit (40), thereby forming a ring-shaped enclosing type such that the wind will be smoothly concentrated by the reduction cover (42a) and the flow direction will be changed thereby; meanwhile, each of the air flows will be separated by the separation portion (22a) and delivered to the heat source of the heat sink (20b).

15. The turbo-guiding type cooling apparatus as recited in claim 14 wherein a straight fin (425) of the reduction cover (42a) has a connection surface (426) in the middle thereof and is fixed by a screw (427) fitting into a connection hole (26) at the top of the heat sink (20b).

16. The turbo-guiding type cooling apparatus as recited in claim 14 wherein the heat-conducting module includes a conic and arched periphery.
